# EUROPÄISCHE PATENTANMELDUNG

(11) **EP 2 848 950 A1**
(43) Veröffentlichungstag der Anmeldung: **18.03.2015**
(21) Anmeldenummer: 14003004.0
(22) Anmeldetag: 01.09.2014
(51) Int. Cl.: G01R 31/02, H04B 1/04

(54) **Sendeantennenanlage mit einer Überwachung einer elektrischen Leitungseigenschaft und Einbauteil mit einer Einkopplung einer Widerstandsmesseinrichtung**

(30) Priorität: 02.09.2013 DE 102013014476
(71) Anmelder: Media Broadcast GmbH, 51103 Köln (DE)
(72) Erfinder: Kirpal, Peter, 63846 Laufach (DE)
(74) Vertreter: Von Kreisler Selting Werner - Partnerschaft von Patentanwälten und Rechtsanwälten mbB

(57) **Zusammenfassung**

Die vorliegende Erfindung betrifft eine Sendeantennenanlage (1) mit einer Sendeleistung von wenigstens 2 kW mit einer Überwachung einer elektrischen Leitungseigenschaft der Sendeantennenanlage,
wobei die Sendeantennenanlage (1) wenigstens einen Leistungstransportpfad (2) zur Leistungszufuhr zu wenigstens einer ersten Sendeantenne (3) sowie wenigstens eine Widerstandsmesseinrichtung (5) zur Bestimmung eines ohmschen Widerstands zur Überwachung der Sendeantennenanlage (1) aufweist,
wobei die Widarstandsmesseinrichtung (5) wenigstens eine Gleichspannungsquelle (6) zur Beaufschlagung wenigstens eines Abschnitts des Leistungstransportpfads (2)
mit einer Messgleichspannung sowie wenigstens ein Messgerät (7) zur Bestimmung eines ohmschen Widerstands bezüglich zumindest des mit der Mesegleichspannung beaufschlagten Abschnitts aufweist.

## Beschreibung

Die Erfindung betrifft eine Sendeantennenanlage mit einer Sendeleistung von wenigstens 2 kW mit einer Überwachung einer elektrischen Leitungseigenschaft der Sendeantennenanlage. Des Weiteren wird ein Einbauteil mit zumindest einer Einkopplung einer Widerstandsmesselnrichtung in einen Leistungstransportpfad einer solchen Sendeantennenanlage vorgeschlagen.

Sendeantennenanlagen mit einer Sendeleistung von wenigstens 2 kW werden beispielsweise in der terrestrischen Rundfunksendetechnik genutzt. Beispiele hierfür sind Sendeantennenanlagen, welche für das Versenden von Rundfunkprogrammen In den Frequenzbereichen UKW, DAB und teilweise auch die DVB-T genutzt werden. Sendeantennenanlagen dieser Beispiele weisen wenigstens eine Sendeantenne, in den meisten Fällen auch eine Mehrzahl von Sendeantennen auf. Zur Erhöhung der Reichweite des eingangs genannten Sendeantennenanlagetyps sind die Sendeantennen häufig in hohen Bauwerken untergebracht, wie beispielsweise in Funktürmen.

Bei den bekannten Sendeantennenanlagen ergibt sich das Problem, dass im Laufe der Zeit Änderungen der elektrischen Leitungseigenschaften der Gesamtanlage sich ergeben können. Insbesondere können elektrischen Leitungseigenschaften des Leistungstransportpfadwerks auftreten, mittels welchen das Sendesignal von einer Sendeanlage zu der Sendeantenne beziehungsweise den Sendeantennen geführt werden. Beispielsweise kann sich durch Eintritt von Feuchtigkeit, Luftspaltsbildung, Rosteffekte oder Ähnliches eine zumindest lokal deutliche Erhöhung eines ohmschen Wirkwiderstands der Sendeantennenanlage ergeben. Eine hierdurch bewirkte. Umsetzung von Hochfrequenzleistung in Wärme kann unter ungünstigen Umständen einen Brandherd herbeiführen und hierdurch eine Beschädigung der Gesamtanlage bis hin zur Zerstörung bewirken, womit nicht zuletzt erhebliche Kosten einhergehen können.

Die Erfindung liegt die Aufgabe zu Grunde, die Sicherheit der Sendeantennenanlage, insbesondere hinsichtlich drohender Beschädigung durch Brandherde, zu erhöhen.

Die Aufgabe wird mit einer Sendeantennenanlage mit einer Sendeleistung von wenigstens 2 kW mit einer Überwachung einer elektrischen Leitungseigenschaft der Sendeantennenanlage nach Anspruch 1 und mit einem Einbauteil mit zumindest einer Einkopplung einer Widerstandsmesseinrichtung in einen Leistungstransportpfad der Sendeantennenanlage mit einer Sendeleistung von wenigstens 2 kW nach Anspruch 13 gelöst. Des Weiteren wird die Aufgabe mit einem Verfahren zur Überwachung einer elektrischen Leitungseigenschaft einer Sendeantennenanlage mit einer Sendeleistung von wenigstens 2 kW nach Anspruch 19 gelöst. Weitere vorteilhafte Ausgestaltungen und Weiterbildungen gehen aus der nachfolgenden Beschreibung hervor. Ein oder mehrere Merkmale aus den Ansprüchen, der Beschreibung wie auch den Figuren können mit ein oder mehreren weiteren Merkmalen der Offenbarung zu zusätzlichen weiteren Ausgestaltungen der Erfindung verknüpft werden. Insbesondere können auch ein oder mehrere Merkmale aus den unabhängigen Ansprüchen durch ein oder mehrere andere Merkmale aus der Beschreibung und/oder den Figuren ersetzt werden. Die vorgeschlagenen Ansprüche sind vorzugsweise nur als ein Entwurf zur Formulierung des Gegenstands aufzufassen, ohne diesen aber zu beschränken.

Es wird eine Sendeantennenanlage mit einer Sendeleistung von wenigstens 2 kW mit einer Überwachung einer elektrischen Leitungseigenschaft der Sendeantennenanlage vorgeschlagen.

Die Sendeantennenanlage weist wenigstens einen Leistungstransportpfad zur Leistungszufuhr zu wenigstens einer ersten Sendeantenne sowie wenigstens eine Widerstandsmesseinrichtung zur Bestimmung eines ohmschen Widerstands auf zur Überwachung der Sendeantennenanlage.

Die Widerstandsmesseinrichtung umfasst wenigstens eine Gleichspannungsquelle zur Beaufschlagung wenigstens des Abschnitts des Leistungstransportpfads mit einer Messgleichspannung. Des Weiteren weist die Widerstandsmesseinrichtung wenigstens ein Messgerät zur Bestimmung des Widerstands des Abschnitts auf, der mit der Messgleichspannung beaufschlagt ist.

In einer besonders bevorzugten Ausgestaltung kann die vorgeschlagene Überwachung bei Sendeleistungen bis zu 50 kW, vorzugsweise von vorzugsweise 2 kW bis 50 kW funktionsfähig genutzt werden.

Bei einem Messgerät zur Bestimmung des Widerstands kann es sich um ein Ohmmeter handeln, es kann jedoch ebenfalls zusätzlich oder alternativ beispielsweise vorgesehen sein, dass ein Messgerät vorgesehen ist, welches eine indirekte Bestimmung eines Widerstands vorsieht. So kann zum Beispiel eine Redundanzmessung vorgesehen sein, beispielsweise zum Abgleich und/oder zum Gegenprüfen, Beispielsweise kann eine indirekte Bestimmung über eine Ermittlung eines elektrischen Stroms und/oder einer elektrischen Spannung vorgesehen sein.

In einer Ausgestaltung der Sendeantennenanlage kann beispielsweise vorgesehen sein, dass die Widerstandsmesseinrichtung in einem elektrischen Speiseleitungsbereich des Leistungstransportpfads angeordnet ist.

Der Speiseleitungsbereich des Leistungstransportpfad bezeichnet einen Bereich der Sendeantennenanlage, welcher vorzugsweise als ein HF-Kabel oder als ein HF-Kabelbündel ausgebildet ist, welches zu der ersten Sendeantenne in führt.

In einer bevorzugten Ausgestaltung der Sendeantennenanlage kann beispielsweise vorgesehen sein, dass die Widerstandsmesseinrichtung an bzw. in einem HF-Kabel oder an bzw. in einem Verrohrungsabschnitt des Leistungstransportpfads angeordnet ist.

Ein Vorteil einer Anordnung der Widerstandsmesseinrichtung an bzw. in einem HF-Kabel oder an bzw. in einem Verrohrungsabschnitt des Leistungstransportpfads ist beispielsweise, dass durch die unmittelbare Anordnung an die bereits bestehende Infrastruktur der Sendeantennenanlage ein kostengünstiges Anbringen der Widerstandsmesseinrichtung möglich ist, während diese gleichzeitig effizient funktioniert und flexibel positioniert werden kann. So kann eine Widerstandsmesseinrichtung zum Beispiel versetzbar angeordnet werden. Eine weitere Ausgestaltung sieht beispielswiese vor, dass die Widerstandsmesseirichtung nicht permanent eingebaut ist. Vielmehr kann gemäß einer Ausgestaltung diese vollständig oder zumindest teilweise nur zeitweise ein- bzw. angeordnet im Leistungstransportpfad angeordnet sein. So kann zum Beispiel mittels einer transportablen Überprüfungseinrichtung eine Überprüfung des Leistungstransportpfades erfolgen bzw. eine Überprüfung der permanent eingebauten Überwachung des Leistungstransportpfads gemäß des hier beschriebenen Systems erfolgen.

In einer bevorzugten Ausgestaltung der Sendeantennenanlage kann beispielsweise vorgesehen sein, dass die Widerstandsmesseinrichtung an einem Speiseleitungsbeginn angeordnet ist.

Eine Anordnung der Widerstandsmesseinrichtung an einem Speiseleitungsbeginn hat insbesondere den Vorteil zur Folge, eine vollständige Überwachung der jenseits des Speiseleitungsbeginns befindlichen Infrastruktur gegen Veränderung des Widerstands ermöglichen zu können. So wird insbesondere eine vollständige Überwachung des Leistungstransportpfads sowie der Sendeantenne gegen Veränderung des Widerstands ermöglicht.

In einer Ausgestaltung der Sendeantennenanlage kann beispielsweise vorgesehen sein, dass die Widerstandsmesseinrichtung in einem bestückbaren Schaltfeld des Speiseleitungsbeginns angeordnet Ist.

Ein Einbringen der Widerstandsmesseinrichtung in einem bestückbaren Schaltfeld des Speiseleitungsbeginns hat den Vorteil zur Folge, dass das eine flexible Bestückung der Sendeantennenanlage möglich ist.

Des Weiteren hat ein Einbringen der Widerstandsmesseinrichtung in einem bestückbaren Schaltfeld des Speiseleitungsbeginn den Vorteil, dass bereits zur Verfügung stehende, zum Einbringen in das Schaltfeld vorgesehene Bauteile mit der integrierten Widerstandsmesseinrichtung dahingehend modifiziert und genutzt werden können, dass die vorhandene Infrastruktur ansonsten weitgehend unverändert genutzt werden kann.

Gleichzeitig ergibt sich hierdurch der Vorteil, dass am Speiseleitungsbeginn des Leistungstransportpfads der Sendeantennenanlage die Widerstandsmesseinrichtung positioniert ist, was aus den eingangs genannten Gründen vorteilhaft ist. Ein weiterer Vorteil ist, dass die in der Sendetechnik üblichen Schaltfelder verwendet werden können, welche zu Beginn einer jeden Speiseleitung in Richtung zu den Sendeantennenanlage installiert sind. Derartige Schaltfelder sind in vielen Fällen mit so genannten Bügelsteckern bestückt.

Hierbei kann auch beispielsweise vorgesehen sein, dass mehr als ein Bügelstecker in paralleler Anordnung genutzt werden.

Bei der in Rundfunksendeantennenanlagen oftmals verwendeten Nutzung zweier Halbantennen für ein gleiches Frequenzspektrum kann vorgesehen sein, für jede der Halbantennen eine eigens vorgesehene Widerstandsmesseinrichtung und/oder ein eigens vorgesehenes Gleichstromeinspeiseglied zu verwenden.

Gleichzeitig kann vorgesehen sein, dass die Widerstandsmesseinrichtung vollständig oder teilweise in einem Bügelstecker eingebaut ist, der zumindest ein Gleichstromeinspeiseglied aufweist.

In einer Ausgestaltung der Sendeantennenanlage kann beispielsweise vorgesehen sein, dass die Widerstandsmesseinrichtung ein Gleichstromeinspeiseglied aufweist.

In einer Ausgestaltung der Sendeantennenanlage, in welcher die Widerstandsmesseinrichtungen ein Gleichstromeinspeiseglied aufweist, kann der Leistungstransportpfad der Sendeantennenanlage, welcher während des Betriebs für den Transport von Hochfrequenzleistungen vorgesehen ist, mit einem Gleichstrom beaufschlagt werden.

In einer Ausbildung der Sendeantennenanlage kann beispielsweise vorgesehen sein, dass das Gleichstromeinspeiseglied ein erstes Kontaktelement und ein zweites Kontaktelement aufweist. Es kann des Weiteren vorgesehen sein, dass das erste Kontaktelement und das zweite Kontaktelement beispielsweise mittels wenigstens eines Kondensators kapazitiv gekoppelt sind.

Bei einer Anordnung des Gleichstromeinspeiseglieds zwischen der Sendeanlage und dem Leistungstransportpfad bewirkt die kapazitive Kopplung, dass die zu transportierende HF-Leistung weiterhin zwischen Sendeanlage und Leistungstransportpfad passieren kann, der Pfad für einen Gleichstrom jedoch aufgrund der kapazitiver Kopplung gesperrt ist.

In einer Ausgestaltung der Sendeantennenanlage kann beispielsweise vorgesehen sein, dass von einer ersten Verbindungsleitung des ersten Kontaktelements mit dem zweiten Kontaktelement ausgehend eine zu einem dritten Kontaktelement hinführende zweite Verbindungsleitung angeordnet ist.

In einer bevorzugten Ausgestaltung der Sendeantennenanlage ist die zweite Verbindungsleitung von einer Seite der ersten Verbindungsleitung ausgehend, welche der Leistungstransportpfadseite des Kondensators zugewandt ist. Hierdurch wird eine Möglichkeit einer Verbindung des Leistungstransportpfads zu einem Ende der zweiten Verbindungsleitung geschaffen, wohingegen eine Verbindung eines Endes der zweiten Verbindungsleitung mit der Sendeanlage über einen Gleichstrom durch die kapazitive Kopplung des ersten Kontaktelements unterbunden ist.

In einer Ausgestaltung der Sendeantennenanlage kann beispielsweise vorgesehen sein, dass die zweite Verbindungsleitung wenigstens ein Kopplungsglied des Gleichstromeinspeiseglieds aufweist zur Verbindung des zweiten Kontaktelements mit dem dritten Kontaktelement. Es kann bevorzugt vorgesehen sein, dass das Kopplungsglied als λ/4-Stichleitungs-Anpassung an die Sendeantenne oder als L-C-Parallelschwingkreis ausgebildet ist.

Es kann in einer anderen Ausgestaltung auch vorgesehen sein, dass das Kopplungsglied als Drossel ausgebildet ist.

Vorteil eines Einbringens eines Kopplungsglieds, welches als λ/4-Stichleitungs-Anpassung, als L-C-Parallelsehwingkreis oder als Drossel ausgebildet ist, ist unter anderem eine mittels destruktiver Interferenz der zum Leistungstransportpfad führenden Wechselspannung erfolgende Dämpfung in Richtung des Messgerätes und/oder der Gleichspannungsquelle, so dass diese von den Wechselspannung leitenden Bauteilen der Sendeantennenanlage getrennt sind.

Die Auslegung des Kopplungsglieds bei einer Bandbreite eines von der Sendeantenne emittierten Frequenzbereichs wird beispielweise dahingehend vorgenommen, dass das Kopplungsglied eine Frequenz etwa in der Mitte des Frequenzbereichs filtert. So kann beispielsweise bei einer Ausgestaltung eines Kopplungsglieds als λ/4-Stichleitungs-Anpassung vorgesehen sein, dass bei dem Beispiel einer UKW-Sendeantennenanlage, welche Signale aus einem Frequenzbereich von 87-108 MHz emittiert, eine mittlere Frequenz von f = (87+108) MHz/2 = 97,5 MHz zu Grunde gelegt wird. Aus einer mittleren Frequenz von 97,5 MHz ergibt sich aus der Formel λ = c/f mit den genannten Größen ein Wert von λ = 3,07 m. In der Formel λ = c/f ist c die Lichtgeschwindigkeit und f die oben genannte Frequenz. Unter Nutzung des ermittelten Werts ergibt sich für die λ/4-Stlchleitungs-Anpassung eine notwendige Länge der λ/4-Stichleitungs von 3,07 m/4 = 0,77 m. Bei der Auslegung einer λ/4-Stichleitungs-Anpassung anhand eines Mittelwerts eines Frequenzbereichs haben sich in einem Feldversuch ein Rückflussdämpfungswert von > 21 dB und eine vernachlässigbar kleine Durchgangsdämpfung gezeigt, so dass die bestimmungsgemäße Funktion des Gleichstromeinspeiseglieds in Kombination mit einer isolationsmesseinrichtung gewährleistet war. Gleichzeitig wurden die Übertragungsparameter der emittierten Signale nicht nachweisbar beeinflusst, wodurch die Funktionsfähigkeit der beschriebenen Versuchsanordnung belegt ist.

In einer Ausgestaltung der Sendeantennenanlage kann beispielsweise vorgesehen sein, dass die zweite Verbindungsleitung einen zwischen dem Kopplungsglied und dem dritten Kontaktelement angeordneten Übergangskondensator des Gleichstromeinspeiseglieds aufweist.

In einer weiteren Ausgestaltung der Sendeantennenanlage kann vorgesehen sein, dass zwischen dem Kopplungsglied und dem dritten Kontaktelement ein HF-neutraler Raum des Gleichstromeinspeiseglieds angeordnet ist, der bevorzugt einen Gasentladungs-Überspannungsableiter aufweist.

In einer weiteren Ausgestaltung der Sendeantennenanlage kann vorgesehen sein, dass die Widerstandsmesseinrichtung ein mit der Anlage verbundenes, bevorzugt austauschbares und/oder steckbares, Einbauteil aufweist, das zumindest das Gleichstromeinspeiseglied enthält.

Der Vorteil sowohl des Übergangs-Kondensators und/oder des Gasentladungsüberspannungsableiters ist, dass eine Zerstörung einzelner Bauteile durch spontane Spannungserhöhung, beispielsweise durch direkten oder indirekten folgenden Blitzschlag, weitgehend vermieden wird.

in einer weiteren Ausgestaltung der Sendeantennenanlage kann beispielsweise vorgesehen sein, dass zumindest ein Kontaktelement der Widerstandsmesseinrichtung, bevorzugt alle Kontaktelemente, als Steckbuchse ausgebildet sind, wobei:
- eine erste Steckbuchse mit der Sendeanlage verbunden ist,
- eine zweite Steckbuchse mit dem Leistungstransportpfad verbunden ist und
- eine dritte Steckbuchse, die bevorzugt mit einer Abschirmung versehen ist, zum Schutz vor einem Kontakt mit Gegenständen oder Lebewesen, zumindest mit der Gleichspannungsquelle verbunden ist.

Bevorzugt weist die isolationsmesseinrichtung die Gleichspannungsquelle und das Messgerät zur Bestimmung des Widerstands auf. In Verbindung mit wenigstens dem Gleichstromeinspeiseglied bildet die Steckverbindung des Gleichstromeinspeiseglieds mit der Isolationsmesseinrichtung beispielsweise die Widerstandsmesseinrichtung.

Ebenfalls kann auch vorgesehen sein, dass anstelle einer, beispielsweise kompakt ausgebildeten, Isolationsmesseinrichtung eine Kombination wenigstens einer Gleichstromquelle und wenigstens eines Messgerätes an der dritten Steckbuchse angeordnet ist.

Ebenfalls kann auch vorgesehen sein, dass die Widerstandsmesseinrichtung gebildet wird, in dem mehr als eine Gleichstromquelle und mehr als ein Messgerät an der dritten Steckbuchse angeordnet sind.

Ebenfalls sind auch Ausgestaltungen möglich, in welcher das Gleichstromeinspeiseglied, die Gleichstromquelle und/oder das Messgerät in einem kompakten Bauteil angeordnet sind.

Eine Verbindung mit der ersten Steckbuchse, mit der zweiten Steckbuchse und/oder der dritten Steckbuchse kann revisibel lösbar sein, was insbesondere den Vorteil hat, dass die Widerstandsmesseinrichtung oder Bestandteile der Widerstandsmesseinrichtung austauschbar sind.

In einer weiteren Ausgestaltung kann beispielsweise vorgesehen sein, dass das Gleichstromeinspeiseglied als ein kompaktes Bauteil vorgesehen ist, und dass das Gleichstromeinspeiseglied als austauschbares Einbauteil vorliegt.

Ebenfalls kann beispielsweise vorgesehen sein, dass eine Verbindung der dritten Steckbuchse mit der Gleichstromquelle und/oder dem Messgerät oder aber eine Verbindung der dritten Steckbuchse mit der isolationsmesseinrichtung als nicht zerstörungsfrei lösbar ausgeführt ist, beispielsweise als Schweißverbindung.

Es kann beispielsweise eine Messgleichspannung mit einem Wert zwischen 500 V und 1500 V vorgesehen sein.

Bevorzugt kann eine Messgleichspannung mit einem Wert zwischen 750 und 1250 V vorgesehen sein. Auch können unterschiedliche Messgleichspannungen zum Einsatz kommen, die vorzugsweise innerhalb des angegebenen Bereichs liegen.

In einer weiteren Ausgestaltung der Sendeantennenanlage kann beispielsweise vorgesehen sein, dass die Sendeantennenanlage eine Funkantennenanlage ist.

Ein weiterer Gedanke der Erfindung, der abhängig wie auch unabhängig von der oben beschriebenen Sendeantennenanlage angewendet werden kann, betrifft ein Einbauteil.

Es ist ein Einbauteil mit zumindest einer Einkopplung einer Widerstandsmesseinrichtung in einen Leistungstransportpfad einer Sendeantennenanlage mit einer Sendeleistung von wenigstens 2 kW vorgesehen, wobei das Einbauteil wenigstens ein Gleichstromeinspeiseglied aufweist, das umfasst:
- ein bevorzugt als erste Steckbuchse ausgebildetes erstes Kontaktelement zum, bevorzugt senderseitigen, Verbinden,
- ein bevorzugt als zweite Steckbuchse ausgebildetes zweites Kontaktelement zum, bevorzugt leistungstransportseitigen, Verbinden und
- ein bevorzugt als dritte Steckbuchse ausgebildetes drittes Kontaktelement zum Verbinden mit der Widerstandsmesseinrichtung.

Die Widerstandsmesseinrichtung weist bevorzugt eine Isolationsmesseinrichtung auf.

Es kann des Weiteren beispielsweise ein Einbauteil vorgesehen sein, dessen erstes Kontaktelement und zweites Kontaktelement mittels wenigstens eines Kondensators des Gleichstromeinspeiseglieds kapazitiv gekoppelt sind.

In einer Ausgestaltung des Einbauteils kann beispielsweise vorgesehen sein, dass von einer ersten Verbindungsleitung des Gleichstromeinspeiseglieds zwischen dem ersten Kontaktelement und dem zweiten Kontaktelement ausgehend, bevorzugt leistungstransportseitig des Kondensators orientiert, eine zu dem dritten Kontaktelement hinführende zweite Verbindungsleitung des Gleichstromeinspeiseglieds angeordnet ist.

In einer weiteren Ausbildung des Einbauteils kann ein Kopplungsglied vorgesehen sein, dass als Teil der zweiten Verbindungsleitung vorgesehen ist. Das Kopplungsglied ist bevorzugt als λ/4-Stichleitungs-Anpassung an die Sendeantenne und/oder als L-C-Parallelschwingkreis ausgebildet.

In einer weiteren Ausgestaltung ist beispielsweise vorgesehen, dass die zweite Verbindungsleitung einen zwischen dem Kopplungsglied und dem dritten Kontaktelement angeordneten Übergangskondensator aufweist und dass zwischen dem Übergangskondensator und dem dritten Kontaktelement ein HF-neutraler Raum des Gleichstromeinspeiseglieds angeordnet ist, der bevorzugt einen Überspannungsableiter aufweist.

In einer Ausbildung des Einbauteils ist beispielsweise vorgesehen, dass das dritte Kontaktelement eine zweipolige Steckbuchse mit einem ersten Pol und einem zweiten Pol ist, wobei einer der beiden Pole ein Erdungspol ist.

In einer Ausbildung des Einbauteils ist beispielsweise vorgesehen, dass ein Widerstandsmessgerät an das Einbauteil austauschbar angeordnet ist.

Ein weiterer Gedanke der Erfindung, der abhängig wie unabhängig von der oben beschriebenen Sendeantennenanlage angewendet werden kann, betrifft ein Verfahren zur Überwachung einer elektrischen Leitungseigenschaft einer Sendeantennenanlage mit einer Sendeleistung von wenigstens 2 kW.

Es ist ein Verfahren zur Überwachung einer elektrischen Leitungseigenschaft einer Sendeantennenanlage mit einer Sendeleistung von wenigstens 2 kW vorgesehen. Die Sendeantennenanlage weist wenigstens einen Leistungstransportpfad und wenigstens eine erste Sendeantenne auf.

Zur Überwachung wird wenigstens ein Abschnitt des Leistungstransportpfads mit einer Messgleichspannung beaufschlagt und eine ohmsche Widerstandsbestimmung wenigstens des Abschnitts des Leistungstransportpfads vorgenommen,

In einer Ausgestaltung des Verfahrens erfolgt die ohmsche Widerstandsbestimmung zeitabhängig.

In einer bevorzugten Ausbildung des Verfahren wird bei Unterschreiten eines festgesetzten Schwellenwertes des ohmschen Widerstands, bevorzugt bei Unterschreiten eines ohmschen Widerstandswerts zwischen von 100 kOhm und 500 kOhm, besonders bevorzugt bei Unterschreiten eines ohmschen Widerstandswerts zwischen von 150 kOhm und 250 kOhm, ein Alarmsignal ausgegeben.

Die genannten Werte sind hierbei niedrig genug, um etwaige Fehlalarme durch eine wetterbedingte Absenkung der Widerstandswerte, beispielsweise aufgrund von hoher Luftfeuchte und/oder salzhaltiger Luft, zu vermeiden.

Bevorzugt erfolgt die ohmsche Widerstandsbestimmung mit einer gesteuerten Widerstandsbestimmung in kontinuierlicher Weise oder zu vorbestimmten Zeitpunkten.

Es kann des Weiteren eine Verwendung einer Sendeantennenanlage zum überwachten Betrieb einer Fernmeldeanlage unter durchgehender oder planmäßig wiederkehrender Isolationsmessung mittels Beaufschlagung wenigstens eines Abschnitts des Leistungstransportpfads der Sendeantennenanlage mit einer Messgleichspannung und einer ohmschen Widerstandsbestimmung des Abschnitts des Leistungstransportpfads vorgesehen sein.

Beispielsweise kann vorgesehen sein, dass Messungen in äquidistanten Abständen vorgenommen werden. Hierzu ist nicht notwendigerweise eine aktive Regelung notwendig, sondern eine Steuerung kann nach einem zuvor festgelegten Zeitplan erfolgen.

Zur Gewährleistung der gewünschten Funktionsfähigkeit hat sich eine Vornahme von Messungen in Zeitabständen von mehreren Stunden als vollkommen ausreichend erwiesen. Für eine einzelne Messung kann eine vorgenommene Messdauer von wenigen Sekunden bereits völlig ausreichend sein, um ein aussagekräftiges Ergebnis zu erlangen.

Es kann beispielsweise vorgesehen sein, dass Messungen in einem Zeitabstand von N Stunden zwischen einer i-ten Messung und einer (i+1)-ten Messung erfolgen, wobei i eine positive natürliche Zahl ist, die als Laufindex genutzt wird. Die Zahl N kann hierbei eine positive Dezimalzahl zwischen 2 und 10, bevorzugt zwischen 4 und 8, besonders bevorzugt zwischen 5 und 7 sein.

Diese genannten Zeitabstände und Messdauern sind für den gewünschten Zweck ausreichend, da dem Schadensfall eine oft tagelang oder gar wochenlang zu beobachtende Reduktion des gemessenen Widerstands vorhergehen.

Das Messergebnis kann zum Beispiel direkt vor Ort angezeigt werden. Auch besteht die Möglichkeit, dass das Messergebnis übertragen wird, beispielweise über ein Bussystem. Beispielsweise kann eine Fernübertragung vorgesehen sein, die eine Überwachung fernab von der Sendeanlage ermöglicht. Dieses kann zum Beispiel ein zentrales Überwachungszentrum sein, welches in der Lage ist, eine Mehrzahl an Sendeanlagen, Sendemasten und Funktürme an unterschiedlichen Orten zu überwachen. Vorzugsweise erfolgt die Überwachung computergesteuert. Eine Messung kann dadurch nicht nur überwacht sondern auch computergesteuert ausgelöst werden. Darüber hinaus besteht die Möglichkeit, die Messung manuell auszulösen. Vorzugsweise werden die Messergebnisse gespeichert und können automatisiert ausgewertet werden, zum Beispiel statistisch ausgewertet werden. Beispielweise kann darüber eine Instandsetzung getriggert werden, insbesondere eine vorausschauende Überprüfung, bevor ein größerer Schaden entstehen kann.

Weiterhin kann ein Funkturm mehrere derartige Überwachungen entlang des Leistungstransportpfads verteilt aufweisen, vorzugsweise hintereinander in größeren Abständen zueinander entlang des Pfads. Dieses ermöglicht nicht nur zum Beispiel die gesamte Messung des Leistungstransportpfads. Vielmehr besteht die Möglichkeit, durch jeweilige Messung ein oder mehrere Fehlerstellen besser entlang des Leistungstransportpfads lokalisieren zu können. So kann zum Beispiel über einen Abgleich mit einer Referenzmessung eine Abweichung detektiert werden. Beginnt die Messung mit einer Überwachung, die am nächsten zur Sendeantenne angeordnet ist, aber dort noch keine oder nur geringste Abweichungen zur Referenzmessung vorliegen, kann dann durch die Messung an der nächsten, weiter entfernt von der Sendeantenne angeordneten Überwachung sodann dabei festgestellt werden, ob sich eine Abweichung außerhalb einer Toleranz eingestellt hat. So kann immer weitergehend die Prüfung erfolgen, bis schließlich darüber eien Abweichung zum ersten Mal außerhalb der Toleranz liegt. Dadurch lässt sich die Fehlersteile eingrenzen, was die Arbeiten zum Beispiel in einem Funkturm erleichtert.

Weitere vorteilhafte Ausgestaltungen und Weiterbildungen gehen aus den nachfolgenden Figuren hervor. Die aus den Figuren hervorgehenden Einzelheiten und Merkmale sind jedoch nicht auf diese beschränkt. Vielmehr können ein oder mehrere Merkmale mit ein oder mehreren Merkmalen aus der obigen Beschreibung zu neuen Ausgestaltung verknüpft werden. Insbesondere dienen die nachfolgenden Ausführungen nicht als Beschränkung des jeweiligen Schutzbereiches, sondern erläutern einzelne Merkmale sowie Ihr mögliches Zusammenwirken untereinander.

Es zeigen:
- Fig. 1:: Eine Prinzipskizze einer Sendeantennenanlage mit einer Überwachung einer elektrischen Leitungseigenschaft der Sendeantennenanlage;
- Fig. 2:: eine Prinzipskizze einer beispielhaften Ausgestaltung eines Einbauteils mit einer Einkopplung einer Widerstandsmesseinrichtung;
- Fig. 3:: eine Prinzipskizze einer beispielhaften Ausgestaltung eines Einbauteils mit einer Einkopplung einer Widerstandsmesseinrichtung;
- Fig. 4:: eine Prinzipskizze einer weiteren beispielhaften Ausgestaltung eines Einbauteils mit einer Einkopplung einer Widerstandsmesseinrichtung;
- Fig. 5:: eine Prinzipskizze einer weiteren beispielhaften Ausgestaltung eines Einbauteils mit einer Einkopplung einer Widerstandsmesseinrichtung.

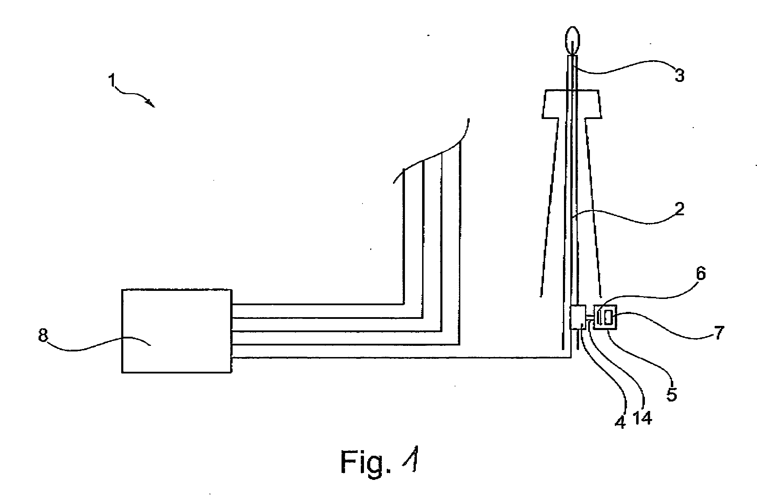

Fig. 1 ist eine Sendeantennenanlage 1 mit einer Sendeleistung von wenigstens 2 kW und mit einer Überwachung einer elektrischen Leitungseigenschaft der Sendeantennenanlage 1 zu entnehmen. Die Sendeantennenanlage 1 weist eine erste Sendeantenne 3 auf, welche über einen Leistungstransportpfad 2 mit über die erste Sendeantenne 3 zu emittierenden Signalen versorgt wird. Die Versorgung der ersten Sendeantenne 3 mit den zu emittierenden Signalen erfolgt ausgehend von einer Sendeanlage 8. Zum Schutz der Sendeantennenanlage 1, insbesondere auch für eine Erhöhung der Sicherheit der Sendeanlage durch Vermeidung beispielsweise von blindwiderstandverursachten Brandentzündungen, weist die Infrastruktur der ersten Sendeantenne 3 zur Überwachung einer elektrischen Leitungseigenschaft der Sendeanlage ein Einbauteil 4 auf, welches in der gezeigten Ausgestaltung der Sendeantennenanlage 1 zum Beispiel in der Verrohrung des Leistungstransportpfad 2 angeordnet ist. An ein drittes Kontaktelement 14 des Einbauteils 4 ist eine als Isolationsmesseinrichtung ausgebildete Widerstandsmesseinrichtung 5 angeordnet. Die Widerstandsmesseinrichtung 5 weist eine Gleichspannungsquelle 6 sowie ein Widerstandsmessgerät 7 auf. Von der Sendeanlage 8 ausgehend sind neben der zu der ersten Sendeantenne 3 führenden Verkabelung vier weitere dargestellte Kabel zu entnehmen, die zu weiteren Antennen hin verlaufen, welche in Fig. 1 jedoch nicht dargestellt sind.

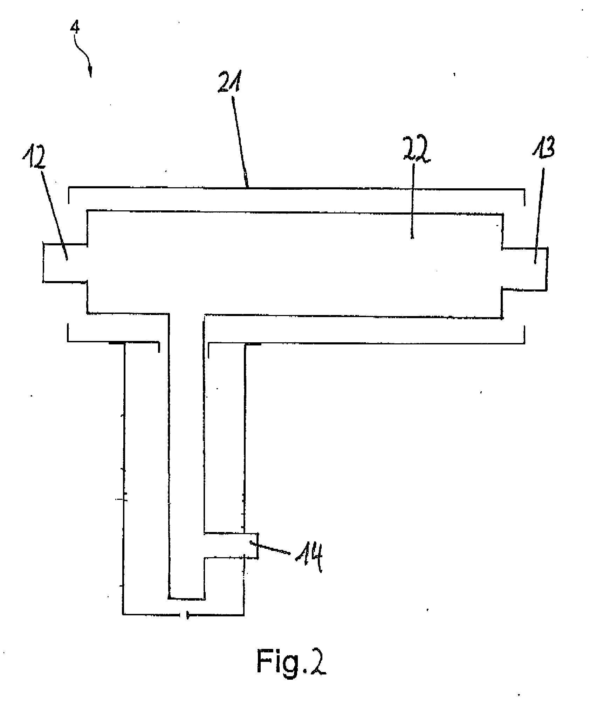

Fig. 2 ist schematisch eine Ausgestaltung eines Einbauteils 4 mit zumindest einer Einkopplung einer Widerstandsmesseinrichtung in einen Leistungstransportpfad einer Sendeantennenanlage mit einer Sendeleistung von wenigstens 2 kW zu entnehmen. Fig. 2 ist ein Gehäuse 21 zu entnehmen innerhalb welchem ein Gleichstromeinspeiseglied (22) angeordnet ist. Das Gleichstromeinspeiseglied weist einen erstes Kontaktelement 12 zur Ankopplung an die Sendeanlage, ein zweites Kontaktelement 13 zur Ankopplung an den Leistungstransportpfad sowie ein drittes Kontakteelement 14 auf. Das dritte Kontaktelement 14 dient dem Anschluss einer Gleichspannungsquelle und/oder eines Messgeräts zur Bestimmung des Widerstands. Ebenfalls kann vorgesehen sein, dass eine Gerätekombination angeschlossen wird, welche eine Gleichspannungsquelle und/oder ein Messgerät zur Bestimmung des Widerstands aufweist. Insbesondere kann vorgesehen sein, dass an das dritte Kontaktelement 14 ein handelsübliches Isolationsmessgerät angeschlossen wird. Eine Gleichspannung zur Beaufschlagung des Leistungstransportpfades wird über das Gleichstromeinspeiseglied 22, das in dem Einbauteil 4 befindlich ist, in den Leistungstransportpfad eingespeist.

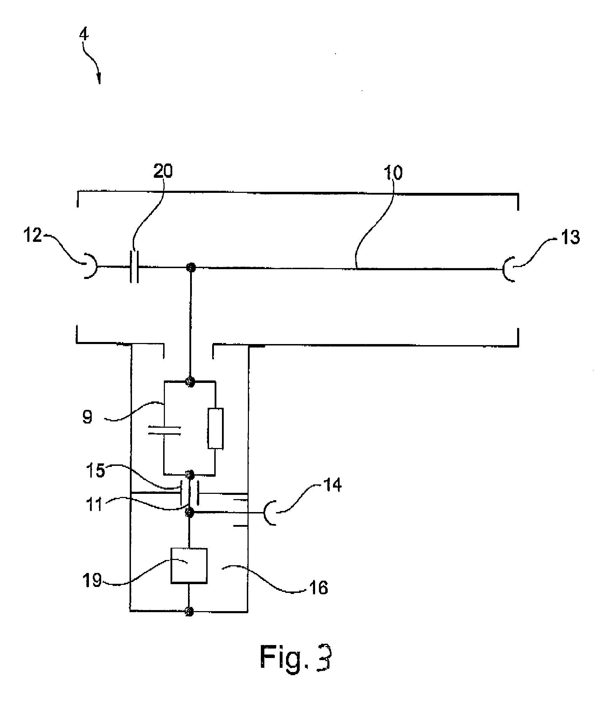

Fig. 3 ist eine Ausgestaltung eines Einbauteils 4 mit zumindest einer Einkopplung einer Widerstandsmesseinrichtung 5 in einen Leistungstransportpfad 2 einer Sendeantennenanlage mit einer Sendeleistung von wenigstens 2 kW zu entnehmen. In der gezeigten Ausgestaltung ist das Einbauteil 4 als Kompaktteil ausgeführt, das vollständig in einem Gehäuse 21 angeordnet ist. Das Einbauteil 4 umfasst in der gezeigten Ausgestaltung ein Gleichstromeinspeiseglied, dessen Ausführung in dem innerhalb des Gehäuses 21 dargestellten Schaltbild dargestellt Ist. Das Gleichstromeinspeiseglied weist ein erstes Kontaktelement 12 und ein zweites Kontaktelement 13 auf. Das erste Kontaktelement 12 ist zur Verbindung des Einbauteils 4 mit einer Sendeseite, in der gezeigten Ausgestaltung mit einer Sendeanlage, der Sendeantennenanlage vorgesehen. Mittels der ersten Verbindungsleitung 10, welche zwischen dem ersten Kontaktelement 12 und dem zweiten Kontaktelement 13 angeordnet ist, ist die Sendeseite der Sendeantennenanlage mit einem Leistungstransportpfad 2 verbunden, welcher an dem zweiten Kontaktelement 13 mit dem Einbauteil verbunden wird. Der Leistungstransportpfad 2 führt ausgehend von der hergestellten Kontaktierung zu wenigstens einer ersten Sendeantenne 3. Die erste Verbindungsleitung 10 weist einen Trennkondensator 20 auf, der die Sendeanlage und den Leistungstransportpfad miteinander kapazitiv koppelt. Durch die kapazitive Kopplung wird erreicht, dass die erste Verbindungsleitung für den Wechselstrom durchlässig ist, der für den Transport des Sendesignals genutzt wird. Gegenüber eines Transports eines Gleichstroms ist die erste Verbindungsleitung über den Trennkondensator 20 hingegen weitestgehend gesperrt, so dass beispielsweise eine Einspeisung von Störsignalen in den Leistungstransportpfad vermieden ist.

Auf der Seite des Trennkondensators 20 angeordnet, weiche dem zweiten Kontaktelement 13 zugewandt ist, ist eine zweite Verbindungsleitung 11 angeordnet. Die zweite Verbindungsleitung 11 verbindet den leistungstransportseitigen Abschnitt der ersten Verbindungsleitung 10 sowie die über das zweite Kontaktelement 13 an dieses angeschlossene Infrastruktur mit dem dritten Kontaktelement 14. Das dritte Kontaktelement 14 ist für die beabsichtigte Einkopplung der Widerstandsmesseinrichtung in den Leistungstransportpfad vorgesehen. Zur Einkopplung der Widerstandsmesseinrichtung in den Leistungstransportpfad ist ausgehend von der ersten Verbindungsleitung 10 hin zum dritten Kontaktelement 14 in der gezeigten Ausgestaltung des Einbauteils 4 zum ersten ein Kopplungsglied 9 angeordnet. Das Kopplungsglied 9 Ist als Parallelanordnung eines Kondensators und einer Spule ausgebildet. Die Verbindung des Kopplungsglieds 9 mit dem dritten Kontaktelement 14 erfolgt über einen Übergangskondensator 15. Des Weiteren ist parallel zu dem dritten Kontaktelement 14 ein Überspannungsableiter 19 als Bestandteil des Gleichstromeinspeiseglieds ausgebildet Der Überspannungsableiter ist innerhalb eines HF-neutralen Raums 16 angeordnet. Der Überspannungsableiter ist in der gezeigten Ausgestaltung als Gasentladungsüberspannungsableiter ausgebildet. Der Gasentladungsüberspannungsableiter Ist in der Lage, elektromagnetische Impulse insbesondere natürlichen Ursprungs, wie direkte oder indirekte Blitzschläge, zu neutralisieren und hierdurch von den angeschlossenen Geräten fernzuhalten. Die Neutralisierung elektromagnetischer Impulse von den angeschlossenen Geräten wird durch die Anordnung des Überspannungsableitung 19 innerhalb des HF-neutralen Raums 16 und durch die elektrostatische Trennung von den übrigen Bauteilen des Gleichstromeinspeiseglieds mittels eines Übergangs Kondensator 15 in besonders effizienter Weise ausgebildet.

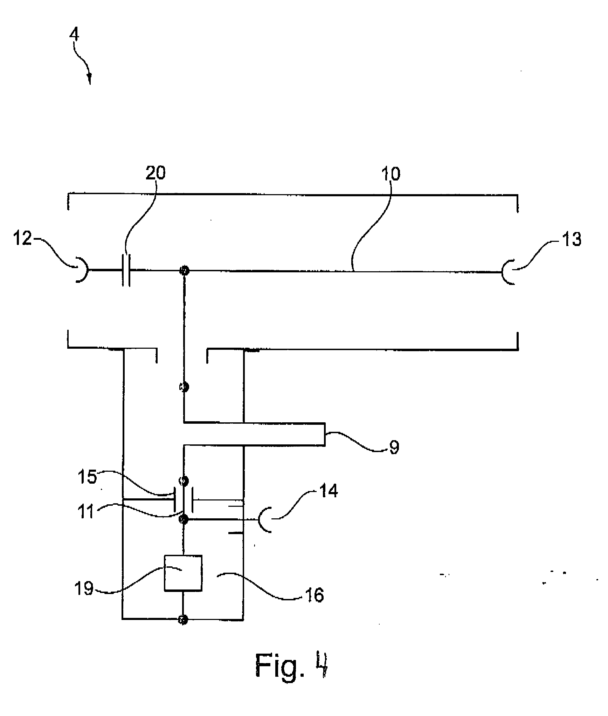

Fig. 4 ist eine weitere Ausgestaltung eines Einbauteils 4 mit zumindest einer Einkopplung einer Widerstandsmesseinrichtung 5 in einen Leistungstransportpfad 2 einer Sendeantennenanlage zu entnehmen. Die Sendeantennenanlage weist eine Sendeleistung von wenigstens 2 kW auf. Im Unterschied zu der in der Fig. 3 dargestellten Ausgestaltung des Einbauteils 4 ist die in der Fig. 4 dargestellte Ausgestaltung eines Einbauteils 4 dahingehend modifiziert, dass die Verbindung des zweiten Kontaktelement 13 mit dem dritten Kontaktelement 14 über ein Kopplungsglied 9 erfolgt, das im Unterschied zu der Ausgestaltung der Fig. 4 als λ/4-Stichleitung ausgebildet ist. Die λ/4-Stichleitung ist auf die Hochfrequenzresonanz der an das dritte Kontaktelement angeschlossenen in der Fig. 4 nicht dargestellten ersten Sendeantenne 3 und dem zu dieser hinführenden Leistungstransportpfad angepasst. Bei der λ/4-Stichleitung handelt es sich um eine leer laufende Leitung, mittels welcher dem Schaltkreis gezielt ein Blindwiderstand zur Verfügung gestellt ist.

In einer Ausgestaltung kann beispielsweise vorgesehen sein, dass an dem dritten Kontaktelement 14 ein Isolationsmessgerät angeschlossen wird, welches ein gleichzeitiges Beaufschlagen des Leistungstransportpfads 2 mit der Gleichspannung und ein Messen des Ohmschen Widerstands des mit der Gleichspannung beaufschlagten Leistungstransport vorsieht.

Beispielsweise kann ein stationäres Isolationsmessgerät des Typs ST 2383 der Firma Sourcetronic GmbH, Fahrenheltstrasse 1, D-28359 Bremen, mit einer einstellbaren Messpannung zwischen 10 V und 1000 V und einem Isomessbereich von 100 kOhm und 10 TOhm mit einem einstellbaren Signalfenster genutzt werden. Eine Auswertung kann über ein akustisches Signal mit einer binären Ausgabe eines Signals bei einem Unterschreiten eines zuvor definierten und eingestellten Grenzwertes erfolgen. Ein Ansteuern und/oder ein Auswerten der Messdaten kann über eine Interface-Schnittstelle RS 232 erfolgen. Der Messzyklus ist einstellbar.

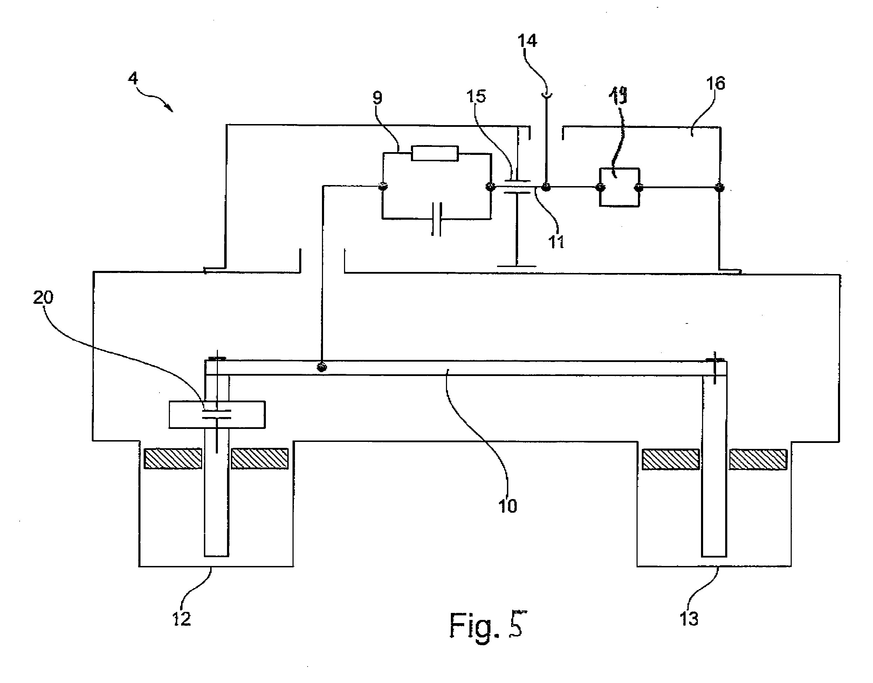

Eine weitere Ausgestaltung eines Einbauteils 4 mit Einkopplung zumindest einer Widerstandsmesseinrichtung 5 ist Fig. 5 zu entnehmen. Die Ausgestaltung der Fig. 5 ist in ihrer prinzipiellen Anordnung der Ausbildung des Gleichstromeinspeiseglieds der Ausgestaltung eines Einbauteils der Fig. 3 vergleichbar. Neben der Lageorientierung der Bauteile zueinander besteht ein wesentlicher Unterschied der Fig. 5 zu der Ausgestaltung der Fig. 3 in der Ausführung des ersten Kontaktelements 12 und des zweiten Kontaktelements 13. Das erste Kontaktelement 12 und das zweite Kontaktelement 13 sind in der der Fig. 5 zu entnehmenden Ausgestaltung als Steckbuchsen ausgebildet. Der Kondensator 10 ist zur Verbesserung der kapazitiven Trennung des ersten Kontaktelements 12 und des zweiten Kontaktelements 13 als Keramikplatte ausgebildet. Für die gezeigte Ausgestaltung der Keramikplatte weist zum Beispiel eine Kapazität von mindestens 500 Mikroferrat auf. Die in der Fig. 5 gezeigte Ausgestaltung entspricht In ihrer Ausbildung zum Beispiel einem Bügelstecker, wie er in vielen Fallen an einem Speiseleitungsbeginn einer Sendeantennenanlage verwendet wird, in der die Widerstandsmesseinrichtung integriert angeordnet ist.

## Patentansprüche

1. Sendeantennenanlage (1) mit einer Sendeleistung von wenigstens 2 kW mit einer Überwachung einer elektrischen Leitungseigenschaft der Sendeantennenanlage,
wobei die Sendeantennenanlage (1) wenigstens einen Leistungstransportpfad (2) zur Leistungszufuhr zu wenigstens einer ersten Sendeantenne (3) sowie wenigstens eine Widerstandsmesseinrichtung (5) zur Bestimmung eines ohmschen Widerstands zur Überwachung der Sendeantennenanlage (1) aufweist,
wobei die Widerstandsmesseinrichtung (5) wenigstens eine Gleichspannungsquelle (6) zur Beaufschlagung wenigstens eines Abschnitts des Leistungstransportpfads (2) mit einer Messgleichspannung sowie wenigstens ein Messgerät (7) zur Bestimmung eines ohmschen Widerstands bezüglich zumindest des mit der Messgleichspannung beaufschlagten Abschnitts aufweist.

2. Sendeantennenanlage (1) nach Anspruch 2, **dadurch gekennzeichnet, dass** die Widerstandsmesseinrichtung (5) in einem elektrischen Speiseleitungsbereich des Leistungstransportpfads angeordnet ist, bevorzugt an einem RF-Kabel oder an einem Verrohrungsabschnitt des Leistungstransportpfads (2), besonders bevorzugt an einem Speiseleitungsbeginn.

3. Sendeantennenanlage (1) nach Anspruch 1 oder nach Anspruch 2, **dadurch gekennzeichnet, dass** die Widerstandsmesseinrichtung (5) in einem bestückbaren Schaltfeld des Speiseleitungsbeginns angeordnet ist.

4. Sendeantennenanlage (1) nach einem der vorhergehenden Ansprüche, **dadurch gekennzeichnet, dass** die Widerstandsmesseinrichtung (5) ein Gleichstromeinspeiseglied (22) aufweist, an der die Gleichspannungsquelle (6) angeordnet ist zur Gleichstromeinspeisung in den Leistungstransportpfad mittels des Gleichstromeinspeiseglieds (22).

5. Sendeantennenanlage (1) nach Anspruch 4, **dadurch gekennzeichnet, dass** das Gleichstromeinspeiseglied (22) ein erstes Kontaktelement (12) und ein zweites Kontaktelement (13) aufweist, wobei das erste Kontaktelement (12) und das zweite Kontaktelement (13) mittels wenigstens eines Kondensators kapazitiv gekoppelt sind zur Verbindung der Sendeanlage (8) mit dem Leistungstransportpfad (2).

6. Sendeantennenanlage (1) nach Anspruch 5, **dadurch gekennzeichnet, dass** von einer ersten Verbindungsleitung (10) des ersten Kontaktelements mit dem zweiten Kontaktelement (13) ausgehend, bevorzugt leistungstransportseitig des ersten Kondensators orientiert, eine zu einem dritten Kontaktelement (14) hinführende zweite Verbindungsleitung (11) des Gleichstromeinspeiseglieds (22) angeordnet ist.

7. Sendeantennenanlage (1) nach Anspruch 6, **dadurch gekennzeichnet, dass** die zweite Verbindungsleitung (11) wenigstens ein, bevorzugt als λ/4-Stichleltungs-Anpassung an die Sendeantenne oder als L-C-Parallelschwingkreis ausgebildetes, Kopplungsglied (9) des Gleichstromeinspeiseglieds (22) aufweist zur Verbindung des zweiten Kontaktelements (13) mit dem dritten Kontaktelement (14).

8. Sendeantennenanlage (1) nach Anspruch 7, **dadurch gekennzeichnet, dass** die zwei-te Verbindungsleitung (11) einen zwischen dem Kopplungsglied (9) und dem dritten Kontaktelement (14) angeordneten Übergangskondensator (15) des Gleichstromeinspeiseglieds (22) aufweist.

9. Sendeantennenanlage (1) nach Anspruch 7 oder nach Anspruch 8, **dadurch gekennzeichnet, dass** zwischen dem Kopplungsglied (9) und dem dritten Kontaktelement (14) ein HF-neutraler Raum (16) des Gleichstromeinspeiseglieds (22) angeordnet ist, der bevorzugt einen Gasentladungs-Überspannungsableiter (19) aufweist.

10. Sendeantennenanlage (1) nach einem der Ansprüche 1 bis 9, **dadurch gekennzeichnet, dass** die Widerstandsmesseinrichtung (5) ein mit der Anlage verbundenes, bevorzugt austauschbares und/oder steckbares, Einbauteil (4) aufweist, das zumindest das Gleichstromeinspeiseglied (22) enthält.

11. Sendeantennenanlage (1) nach einem der Ansprüche 1 bis 10, **dadurch gekennzeichnet, dass** zumindest ein Kontaktelement, bevorzugt alle Kontaktelemente, als Steckbuchse ausgebildet sind, wobei:
- eine erste Steckbuchse mit der Sendeanlage (8) verbunden ist,
- eine zweite Steckbuchse mit dem Leistungstransportpfad (2) verbunden ist und
- eine dritte Steckbuchse, die bevorzugt mit einer Abschirmung versehen ist zum Schutz vor einem Kontakt mit Gegenständen oder Lebewesen, zumindest mit der Gleichspannungsquelle (6) verbunden Ist, bevorzugt mit einer isolationsmesseinrichtung, die die Gleichspannungsquelle (6) und das Messgerät (7) zur Bestimmung des Widerstands umfasst.

12. Sendeantennenanlage (1) nach einem der Ansprüche 1 bis 11, dadurch gekennenzeichnet, dass die Sendeantennenanlage (1) eine Funkantennenanlage ist.

13. Einbauteil (4) mit zumindest einer Einkopplung einer, bevorzugt eine Isolationsmesseinriehtung aufweisenden, Widerstandsmesseinrichung in einen Leistungstransportpfad (2) einer Sendeantennenanlage (1) mit einer Sendeleistung von wenigstens 2 kW, wobei das Einbauteil wenigstens ein Gleichstromeinspelsoglied (22) aufweist, das umfasst:
- ein bevorzugt als erste Steckbuchse ausgebildetes erstes Kontaktelement (12) zum, bevorzugt senderseitigen, Verbinden,
- ein bevorzugt als zweite Steckbuchse ausgebildetes zweites Kontaktelement (13) zum, bevorzugt leistungstransportseitigen, Verbinden und
- ein bevorzugt als dritte Steckbuchse ausgebildetes drittes Kontaktelement (14) zum Verbinden mit der Widerstandsmesseinrichtung.

14. Einbauteil (4) nach Anspruch 13, **dadurch gekennzeichnet, dass** das erste Kontaktelement und das zweite Kontaktelement mittels wenigstens eines Kondensators des Gleichstromeinspeiseglieds (22) kapazitiv gekoppelt sind.

15. Einbauteil (4) nach Anspruch 14, **dadurch gekennzeichnet, dass** von einer ersten Verbindungsleitung (10) des Gleichstromeinspeiseglieds (22) zwischen dem ersten Kontaktelement (12) und dem zweiten Kontaktelement (13) ausgehend, bevorzugt leistungstransportseitig des Kondensators orientiert, eine zu dem dritten Kontaktelement (14) hinführende zweite Verbindungsleitung (11) des Gleichstromeinspeiseglieds (22) angeordnet ist, und dass die zweite Verbindungsleitung (11) wenigstens ein Kopplungsglied, bevorzugt ein als λ/4-Stichleitungs-Anpassung an die Sendeantenne und/oder wenigstens ein als L-C-Parallelschwingkreis ausgebildetes Kopplungsglied (9), aufweist.

16. Einbauteil (4) nach Anspruch 15, **dadurch gekennzeichnet, dass** die zweite Verbindungsleitung (11) einen zwischen dem Kopplungsglied (9) und dem dritten Kontaktelement (14) angeordneten Übergangskondensator (15) aufweist und dass zwischen dem Übergangskondensator (15) und dem dritten Kontaktelement (14) ein HF-neutraler Raum (16) des Gleichstromeinspeiseglieds (22) angeordnet ist, der bevorzugt einen Überspannungsableiter (19) aufweist.

17. Einbauteil (4) nach einem der Ansprüche 13 bis 16, **dadurch gekennzeichnet,**
- **dass** das dritte Kontaktelement (14) eine zweipolige Steckbuchse mit einem ersten Pol und einem zweiten Pol ist, wobei einer der beiden Pole ein Erdungspol ist.

18. Einbauteil (4) nach einem der Ansprüche 13 bis 17, **dadurch gekennzeichnet, dass** ein Widerstandsmessgerät an das Einbauteil austauschbar angeordnet ist.

19. Verfahren zur Überwachung einer elektrischen Leitungseigenschaft einer Sendeantennenanlage (1) mit einer Sendeleistung von wenigstens 2 kW, die wenigstens einen Leistungstransportpfad (2) und wenigstens eine erste Sendeantenne (3) aufweist, wobei
zur Überwachung wenigstens ein Abschnitt des Leistungstransportpfads (2) mit einer Messgleichspannung beaufschlagt wird und eine ohmsche Widerstandsbestimmung wenigstens des Abschnitts des Leistungstransportpfads (2) erfolgt.

20. Verfahren nach Anspruch 19, wobei die ohmsche Widerstandsbestimmung zeitabhängig erfolgt und bei Unterschreiten eines festgesetzten Schwellenwertes des ohmschen Widerstands, bevorzugt bei Unterschreiten eines ohmschen Widerstandswerts zwischen von 100 kOhm und 500 kOhm, besonders bevorzugt bei Unterschreiten eines ohmschen Widerstandswerts zwischen von 150 kOhm und 250 kOhm, ein Alarmsignal ausgegeben wird, bevorzugt mit einer gesteuerten Widerstandsbestimmung in kontinuierlicher Weise und/oder zu vorbestimmten Zeitpunkten.

21. Verwendung einer Sendeantennenanlage (1) nach einem der Ansprüche 1 bis 12 zum überwachten Betrieb einer Fernmeldeanlage unter durchgehender oder planmäßig wiederkehrender Isolationsmessung mittels Beaufschlagung wenigstens eines Abschnitts des Leistungstransportpfads (2) der Sendeantennenanlage (1) mit einer Messgleichspannung und einer ohmschen Widerstandsbestimmung des Abschnitts des Leistungstransportpfads.
